(19) Europäisches Patentamt
European Patent Office
Office européen des brevets

(11) **EP 2 771 719 B1**

(12) **EUROPÄISCHE PATENTSCHRIFT**

(45) Veröffentlichungstag und Bekanntmachung des Hinweises auf die Patenterteilung:
**02.01.2019  Patentblatt 2019/01**

(21) Anmeldenummer: **11788380.1**

(22) Anmeldetag: **25.11.2011**

(51) Int Cl.:
**G01T 7/00** *(2006.01)*

(86) Internationale Anmeldenummer:
**PCT/EP2011/005943**

(87) Internationale Veröffentlichungsnummer:
**WO 2013/060348 (02.05.2013 Gazette 2013/18)**

(54) **ELEKTRONISCHES GERÄT, INSBESONDERE MOBILTELEFON, ZUR STRAHLUNGSDETEKTION**

ELECTRONIC DEVICE, IN PARTICULAR MOBILE TELEPHONE, FOR DETECTING RADIATION

APPAREIL ÉLECTRONIQUE, NOTAMMENT TÉLÉPHONE MOBILE, POUR LA DÉTECTION D'UN RAYONNEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.10.2011  PCT/EP2011/005353**
**17.11.2011  PCT/EP2011/005795**

(43) Veröffentlichungstag der Anmeldung:
**03.09.2014  Patentblatt 2014/36**

(73) Patentinhaber:
• **Helmholtz Zentrum München - Deutsches Forschungszentrum für Gesundheit und Umwelt (GmbH)**
**85764 Neuherberg (DE)**
• **Klein, Rolf-dieter**
**80809 München (DE)**
• **Reichl, Mathias**
**93309 Kelheim (DE)**

(72) Erfinder:
• **REICHL, Mathias**
**93309 Kelheim (DE)**
• **HOESCHEN, Christoph**
**85241 Hebertshausen (DE)**

• **KLEIN, Rolf-Dieter**
**80809 München (DE)**

(74) Vertreter: **v. Bezold & Partner Patentanwälte - PartG mbB**
**Akademiestraße 7**
**80799 München (DE)**

(56) Entgegenhaltungen:
**DE-A1-102009 056 055     GB-A- 968 189**
**US-A1- 2004 149 918     US-A1- 2009 012 745**

• **SANJOY MUKHOPADHYAY: "Field-deployable gamma-radiation detectors for DHS use", PROCEEDINGS OF SPIE, Bd. 6706, 1. Januar 2007 (2007-01-01), Seiten 670612-670612-8, XP55043058, ISSN: 0277-786X, DOI: 10.1117/12.738711**
• **A. BARZILOV ET AL: "<title>Network of wireless gamma ray sensors for radiological detection and identification</title>", PROCEEDINGS OF SPIE, Bd. 6579, 27. April 2007 (2007-04-27), Seiten 654012-654012-8, XP55043060, ISSN: 0277-786X, DOI: 10.1117/12.719930**

**Beschreibung**

Die Erfindung betrifft ein elektronisches Gerät, insbesondere ein Mobiltelefon, gemäß dem Hauptanspruch. Moderne Mobiltelefone verfügen oftmals über eine integrierte Digitalkamera zur Aufnahme von Bildern oder Filmen. Hierzu weist die integrierte Digitalkamera einen Bildsensor (z.B. CCD-Sensor oder CMOS-Sensor) mit zahlreichen matrixförmig angeordneten Bildelementen (Pixeln) auf. Bisher wurden derartige Mobiltelefone mit einer integrierten Digitalkamera jedoch noch nicht zur Messung von ionisierender Strahlung eingesetzt.

Aus SANJOY MUKHOPADHYAY: "Field-deployable gamma-radiation detectors for DHS use" (PROCEEDINGS OF SPIE, Bd. 6706, 1. Januar 2007 (2007-01-01), Seiten 670612-670612-8, ISSN: 0277-786X, DOI: 10.1117/12.738711) und A. BARZILOV ET AL: "titleNetwork of wireless gamma ray sensors for radiological detection and identification /title" (PROCEEDINGS OF SPIE, Bd. 6579, 27. April 2007 (2007-04-27), Seiten 654012-654012-8, ISSN: 0277-786X, DOI: 10.1117/12.719930) ist ein elektronisches Gerät gemäß dem Oberbegriff von Patentanspruch 1 bekannt.

Ferner ist zum Stand der Technik hinzuweisen auf DE 10 2009 056055 A1, US 2009/012745 A1, GB 968 189 A und US 2004/149918 A1.

Der Erfindung liegt deshalb die Aufgabe zugrunde, die Redundanz bei der Strahlungsmessung zu verbessern.

Diese Aufgabe wird durch ein entsprechendes elektronisches Gerät gemäß dem Hauptanspruch gelöst.

Die Erfindung beruht zunächst auf der technisch-physikalischen Erkenntnis, dass die in modernen Mobiltelefonen oftmals integrierten Bildsensoren nicht nur für sichtbares Licht empfindlich sind, sondern auch die Messung ionisierender Strahlung ermöglichen, insbesondere gepulster hochenergetischer Strahlung, wie sie beispielsweise bei Computertomographen (CTs) auftritt.

Die Erfindung umfasst deshalb die allgemeine technische Lehre, den Bildsensor in einem derartigen Mobiltelefon oder in einem sonstigen elektronischen Gerät mit einem solchen Bildsensor auch zur Messung ionisierender Strahlung zu verwenden. Die technische Realisierung dieser Idee ist in der nachveröffentlichten Patentanmeldung PCT/EP2011/005353 beschrieben, so dass zur Vermeidung von Wiederholungen auf diese Patentanmeldung verwiesen wird.

Darüber hinaus sieht die Erfindung einen zusätzlichen Strahlungssensor vor, um die ionisierende Strahlung zu messen, wobei es sich beispielsweise um ein herkömmliches Geiger-Müller-Zählrohr oder eine Photodiode (z.B. eine PIN-Photodiode) handeln kann (PIN: Positive intrinsic negative). Die Erfindung sieht also vorzugsweise die Kombination eines herkömmlichen Bildsensors (z.B. CCD-Sensor, CMOS-Sensor) mit einem Strahlungssensor (z.B. Geiger-Müller-Zählrohr, PIN-Photodiode) vor, so dass die ionisierende Strahlung mit zwei verschiedenen Sensortypen gemessen wird, was mit verschiedenen Vorteilen verbunden ist, die noch ausführlich beschrieben werden.

An dieser Stelle ist zu erwähnen, dass es sich bei dem elektronischen Gerät nicht notwendigerweise um ein Mobiltelefon handeln muss. Die Erfindung umfasst vielmehr auch andere Typen von elektronischen Geräten, die einen integrierten Bildsensor aufweisen und die im Rahmen der Erfindung zusätzlich mit einem Strahlungssensor ausgestattet werden.

In einem bevorzugten Ausführungsbeispiel der Erfindung weist das elektronische Gerät eine Auswertungseinheit auf, die eingangsseitig mit dem Bildsensor und mit dem Strahlungssensor verbunden ist und aus den Ausgangssignalen des Bildsensors und des Strahlungssensors einen Strahlungswert (z.B. Dosiswert, Dosisleistungswert) berechnet, der die ionisierende Strahlung wiedergibt.

Zum einen erfasst die Auswertungseinheit die Pixelwerte der einzelnen Bildelemente (Pixel) des Bildsensors und berechnet daraus im Rahmen einer statistischen Auswertung einen entsprechenden Strahlungswert. Die technischen Details dieser Auswertung der einzelnen Pixelwerte sind in der vorstehend erwähnten Patentanmeldung beschrieben, deren Inhalt deshalb der vorliegenden Beschreibung in vollem Umfang zuzurechnen ist.

Zum anderen erhält die Auswertungseinheit von dem Strahlungssensor (z.B. Geiger-Müller-Zählrohr, PIN-Photodiode) einen Strahlungswert.

Die Auswertungseinheit kann dann im Rahmen der Erfindung die von dem Bildsensor und von dem Strahlungssensor gemessenen Strahlungswerte miteinander abgleichen.

Darüber hinaus besteht im Rahmen der Erfindung die Möglichkeit, dass der Bildsensor und der Strahlungssensor unterschiedliche Leistungsmessbereiche aufweisen. So kann der Strahlungssensor (z.B. Geiger-Müller-Zählrohr) beispielsweise zur Messung geringer Strahlungsleistungen dienen, wohingegen der Bildsensor zur Messung hoher Strahlungsleistungen dient.

Beispielsweise kann der Bildsensor einen Messbereich aufweisen, der zu hohen Strahlungsleistungen hin bis in den kilosievert-Bereich reicht, während der Strahlungssensor einen Messbereich aufweisen kann, der zu niedrigen Strahlungsleistungen hin bis in den nanosievert-Bereich reichen kann. Der Bildsensor kann also höherenergetischere Strahlung messen, während der Strahlungssensor niederenergetischere Strahlung messen kann.

Die Kombination eines Bildsensors mit einem Strahlungssensor zur Messung ionisierender Strahlung ist auch vorteilhaft, weil derartige Sensoren in der Regel unterschiedliche Messverfahren anwenden, wodurch Redundanz geschaffen wird.

Darüber hinaus können der Bildsensor und der Strahlungssensor für unterschiedliche Strahlungsarten (z.B. Alpha-Strahlung, Beta-Stahlung, Gamma-Strahlung) empfindlich sein.

In einem Ausführungsbeispiel der Erfindung sind die Bildelemente des Bildsensors mindestens teilweise mit Abschwächern bedeckt, wobei die Abschwächer die einfallende ionisierende Strahlung abschwächen. Derartige Abschwächer können beispielsweise schichtförmig ausgebildet sein und aus Kupfer, Aluminium, Blei oder Plexiglas bestehen. Die Dicke der Abschwächer variiert hierbei vorzugsweise zwischen den einzelnen Bildelementen (Pixeln) des Bildsensors, was bei einer entsprechenden statistischen Auswertung eine hochgenaue Bestimmung der spektralen Energieverteilung der einfallenden ionisierenden Strahlung ermöglicht. Beispielsweise können die Abschwächer eine Dicke aufweisen, die sich von einer Seite des Bildsensors zu der gegenüberliegenden Seite des Bildsensors keilförmig erweitert, so dass die einfallende ionisierende Strahlung auf der einen Seite des keilförmigen Abschwächers nur geringfügig abgeschwächt wird, wohingegen die einfallende ionisierende Strahlung auf der gegenüberliegenden Seite des keilförmigen Abschwächers wesentlich stärker abgeschwächt wird.

Ein derartiger Abschwächer kann im Rahmen der Erfindung auch bei dem Strahlungssensor eingesetzt werden.

Darüber hinaus kann im Strahlengang des Strahlungssensors und/oder des Bildsensors ein Strahlungsfilter angeordnet sein.

Weiterhin ist zu erwähnen, dass die Messempfindlichkeit des Bildsensors in der Regel temperaturabhängig ist. In einem bevorzugten Ausführungsbeispiel der Erfindung ist deshalb ein Temperatursensor vorgesehen, um die Temperatur des Bildsensors und/oder des Strahlungssensors zu erfassen. Die Auswertungseinheit berücksichtigt dann die von dem Temperatursensor gemessene Temperatur des Bildsensors, um Temperaturschwankungen bei der Messung zu kompensieren.

Darüber hinaus kann das erfindungsgemäße elektronische Gerät zusätzlich ein aktives Kühlelement (z.B. ein Peltier-Element) aufweisen, um den Bildsensor aktiv zu kühlen und dadurch die Messempfindlichkeit des Bildsensors zu erhöhen. Die Ansteuerung des aktiven Kühlelements kann hierbei in Abhängigkeit von der gemessenen Temperatur des Bildsensors im Rahmen einer Steuerung oder einer Regelung erfolgen.

Weiterhin kann im Strahlengang des Bildsensors und/oder des Strahlungssensors ein Konverter (z.B. ein Szintillator) angeordnet sein, der die einfallende Strahlung aus einem schlecht detektierbaren Wellenlängenbereich in einen besser detektierbaren Wellenlängenbereich konvertiert. Der Einsatz eines derartigen Konverters ermöglicht also die Messung von einfallender Strahlung in einem Wellenlängenbereich, in dem der Bildsensor bzw. der Strahlungssensor insensitiv ist.

Beim Auslesen des Bildsensors kann das Problem auftreten, dass der Bildsensor eine kurze Totzeit aufweist, so dass innerhalb der Totzeit keine Strahlungsmessung möglich ist. Beim Messen von gepulster Strahlung besteht jedoch die Möglichkeit, dass die einzelnen Strahlungspulse jeweils in die Totzeit des Bildsensors fallen, so dass die einfallende Strahlung nicht detektiert wird.

Zur Vermeidung derartiger auslesebedingter Totzeiten ist in einer Variante der Erfindung vorgesehen, dass mehrere Bildsensoren miteinander kombiniert werden. Dies bietet den Vorteil, dass die Totzeiten der einzelnen Bildsensoren in der Regel keine zeitliche Überlappung aufweisen, so dass zumindest einer der Bildsensoren jederzeit sensitiv ist und eine Strahlungsmessung ermöglichst.

Eine andere Lösung dieses Problems der Totzeiten von Bildsensoren besteht in dem Einsatz der sogenannten ERS-Technologie (ERS: Electronic Rolling Shutter). Dabei werden die einzelnen Bildelemente (Pixel) des Bildsensors jeweils zeilenweise abgetastet und gespeichert, so dass der Bildsensor jeweils nur in einer einzigen Zeile insensitiv ist, während die anderen Zeilen des Bildsensors sensitiv sind und dann eine Strahlungsmessung ermöglichen. Auf diese Weise wird insbesondere bei der Messung gepulster Strahlung verhindert, dass der Bildsensor bei einem Strahlungspuls vollständig insensitiv ist.

Bei der Strahlungsmessung ist zu berücksichtigen, dass das Messergebnis von der Ausrichtung des jeweiligen Strahlungssensors und von der Positionierung des Strahlungssensors abhängt. So kann beispielsweise der Benutzer eines Mobiltelefons mit einem integrierten Strahlungssensor den Strahlungssensor mit seinem Körper abschatten, wodurch der Strahlungssensor einen verfälschten Strahlenwert misst. In einer Variante der Erfindung weist das zur Strahlungsmessung dienende Gerät deshalb mehrere Strahlungssensoren auf, die räumlich verteilt angeordnet und/oder in unterschiedliche Richtungen ausgerichtet sind. Die Auswertungseinheit kann dann die Ausgangssignale der verschiedenen Strahlungssensoren auswerten, um Störgrößen zu unterdrücken.

Darüber hinaus besteht die Möglichkeit, dass der Strahlungssensor in dem Gerät relativ zu dem Gerät in verschiedene Richtungen ausgerichtet werden kann, wobei die räumliche Ausrichtung des Strahlungssensors im laufenden Betrieb geändert werden kann. Beispielsweise kann hierzu ein Stellmotor vorgesehen sein, der den Strahlungssensor in die gewünschte Richtung ausrichtet.

Ferner besteht im Rahmen der Erfindung auch die Möglichkeit, dass mehrere Bildsensoren miteinander kombiniert werden, um eine möglichst genaue Strahlungsmessung zu ermöglichen, wobei auf einen separaten Strahlungssensor auch verzichtet werden kann. Dies ist essentiell für eine spektrale Messung. Beispielsweise kann der zweite Bildsensor teilweise oder vollständig von einem Szintillator abgedeckt sein. Weiterhin besteht die Möglichkeit, einen Strahlungssensor mit mehreren Bildsensoren zu kombinieren.

Das erfindungsgemäße Gerät zur Strahlungsmessung eignet sich insbesondere zur Messung der Strahlenexposition für Flugzeugbesatzungen, die insbesondere bei Langstreckenflügen einer erheblichen Höhenstrahlung ausgesetzt sind. Die Erfindung umfasst deshalb auch einen Flugkörper, wie beispielsweise ein Luftfahrzeug oder ein Raumfahrzeug, mit einem erfindungsgemäßen elektronischen Gerät zur Strahlungsmessung.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

Figur 1            eine Vorderansicht eines erfindungsgemäßen Mobiltelefons mit einer integrierten Digitalkamera und einem ebenfalls integrierten Strahlungssensor,

Figur 2            ein schematisches Blockschaltbild der zur Strahlungsmessung dienenden Komponenten des Mobiltelefons aus Figur 1,

Figur 3            eine schematische Querschnittsdarstellung des Bildsensors des Mobiltelefons aus Figur 1,

Figuren 4a, 4b      das Strahlungsmessverfahren der Mobiltelefone in Form eines Flussdiagramms.

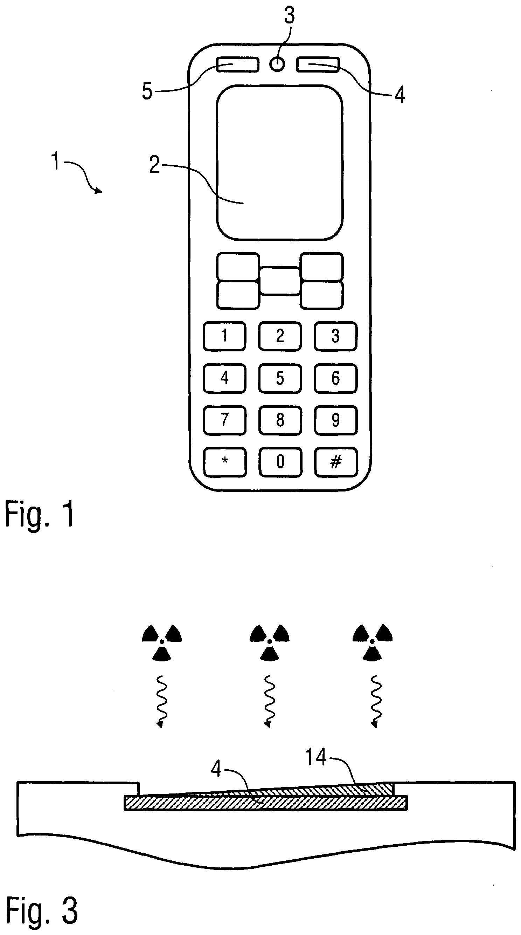

Figur 1 zeigt eine Vorderansicht eines Mobiltelefons 1, das weitgehend herkömmlich aufgebaut ist und u.a. ein LCD-Display 2, einen Lautsprecher 3, einen Bildsensor 4 in Form einer Digitalkamera sowie zusätzlich einen Strahlungssensor 5 in Form einer PIN-Photodiode aufweist. Abgesehen von dem Strahlungssensor 5 entspricht das Mobiltelefon 1 dem Stand der Technik, so dass auf eine detaillierte Beschreibung von Aufbau und Funktionsweise der herkömmlichen Bestandteile des Mobiltelefons 1 verzichtet werden kann.

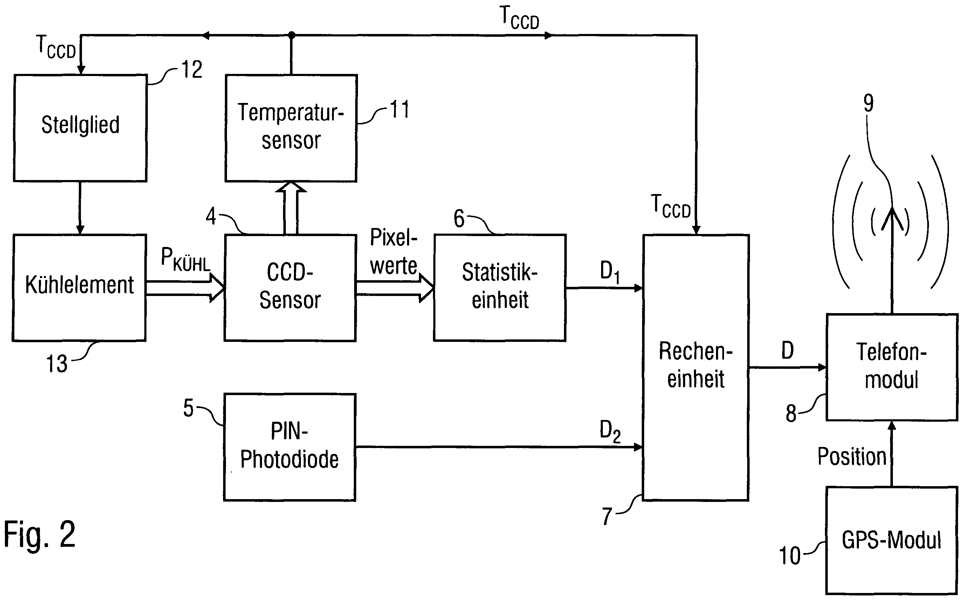

Der Bildsensor 4 dient neben der herkömmlichen Aufnahme von Bildern oder Filmen zur Messung eines Strahlungswerts einer ionisierenden Strahlung in Verbindung mit dem Strahlungssensor 5, wie nachfolgend unter Bezugnahme auf das schematische Blockschaltbild in Figur 2 erläutert wird.

So weist der Bildsensor 4 eine Vielzahl von Bildelementen (Pixeln) auf, die matrixförmig in Zeilen und Spalten angeordnet sind und ein Digitalbild liefern. Die einzelnen Pixelwerte der einzelnen Bildelemente des Bildsensors 4 werden einer Statistikeinheit 6 zugeführt, die im Rahmen einer statistischen Auswertung der Bildwerte der einzelnen Bildelemente (Pixel) des Bildsensors 4 einen Strahlungswert $D_1$ berechnet, wobei es sich beispielsweise um die Dosisenergie oder die Dosisleistung der einfallenden radioaktiven Strahlung handeln kann.

Der Strahlungssensor 5 (z.B. PIN-Photodiode) berechnet ebenfalls einen entsprechenden Strahlungswert $D_2$, wobei die beiden Strahlungswerte $D_1$ und $D_2$ einer Recheneinheit 7 zugeführt werden, die einen einheitlichen Strahlungswert D ermittelt und dann über ein Telefonmodul 8 (z.B. GSM-Modul: Global System for Mobile Communications) und eine Antenne 9 an eine zentrale Überwachungseinrichtung überträgt, die dann die von einer Vielzahl von derartigen Mobiltelefonen 1 gelieferten Strahlungswerte D auswertet.

Darüber hinaus weist das Mobiltelefon 1 noch ein GPS-Modul 10 (GPS: Global Positioning System) auf, das die geografische Position des Mobiltelefons 1 mit Hilfe des satellitengestützten GPS-Navigationssystems ermittelt. Die auf diese Weise ermittelte geografische Position des Mobiltelefons 1 wird dann zusammen mit dem Strahlungswert D ebenfalls über das Telefonmodul 8 und die Antenne 9 an die zentrale Überwachungseinrichtung übertragen. Die zentrale Überwachungseinrichtung kann dann anhand der von den zahlreichen Mobiltelefonen 1 übertragenen Wertepaare aus dem Strahlungswert D und der zugehörigen geografischen Position des jeweiligen Mobiltelefons 1 eine Strahlungskarte erstellen, welche die geografische Verteilung des Strahlungswerts wiedergibt.

Bei der Strahlungsmessung berücksichtigt das Mobiltelefon 1 die Temperaturabhängigkeit der Messung durch den Bildsensor 4. Das Mobiltelefon 1 weist deshalb einen Temperatursensor 11 auf, der die Temperatur des Bildsensors 4 misst und einen entsprechenden Temperaturwert $T_{CCD}$ an die Recheneinheit 7 überträgt. Die Recheneinheit 7 kompensiert dann bei der Bestimmung des Strahlungswerts D etwaige Schwankungen des Temperaturwerts $T_{CCD}$, um eine möglichst temperaturunabhängige Bestimmung des Strahlungswerts D zu ermöglichen.

Darüber hinaus wird der von dem Temperatursensor 11 gemessene Temperaturwert $T_{CCD}$ einem Stellglied 12 zugeführt, das ein Kühlelement 13 (z.B. ein Peltier-Element) so ansteuert, dass das Kühlelement 13 mit einer bestimmten Kühlleistung $P_{KÜHL}$ auf den Bildsensor 4 wirkt, um den Temperaturwert $T_{CCD}$ des Bildsensors 4 möglichst konstant zu halten und dadurch temperaturbedingte Messungenauigkeiten nach Möglichkeit zu vermeiden.

Figur 3 zeigt einen schematischen Querschnitt durch eine Abwandlung des Bildsensors 4 in einem Gehäuse des Mobiltelefons 1. Bei dieser Abwandlung ist im Strahlengang vor dem Bildsensor 4 ein keilförmiger Abschwächer 14 angeordnet, dessen Dicke sich von einer Seite des Bildsensors 4 zu der gegenüberliegenden Seite des Bildsensors 4 keilförmig erweitert. Der Abschwächer 14 besteht beispielsweise aus Kupfer, Aluminium, Blei oder Plexiglas und schwächt die einfallende radioaktive Strahlung in Abhängigkeit von der jeweiligen Dicke des Abschwächers 14 mehr oder weniger ab, was eine spektrale Auswertung der einfallenden radioaktiven Strahlung ermöglicht. So messen die Bildelemente (Pixel) des Bildsensors 4 auf der in der Zeichnung rechten Seite vorrangig radioaktive Strahlung mit einer relativ hohen Energie, die ausreichend ist, um die an dieser Seite relativ dicke Schicht des Abschwächers 14 zu durchdringen. Auf der in der Zeichnung linken Seite messen die Bildelemente des Bildsensors 4 dagegen auch niedrig energetische Strahlung, da der Abschwächer 14 dort sehr dünn ist.

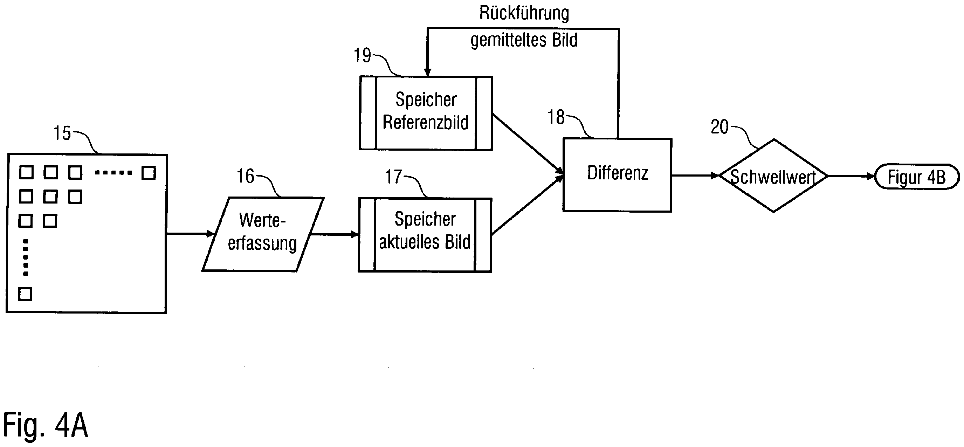

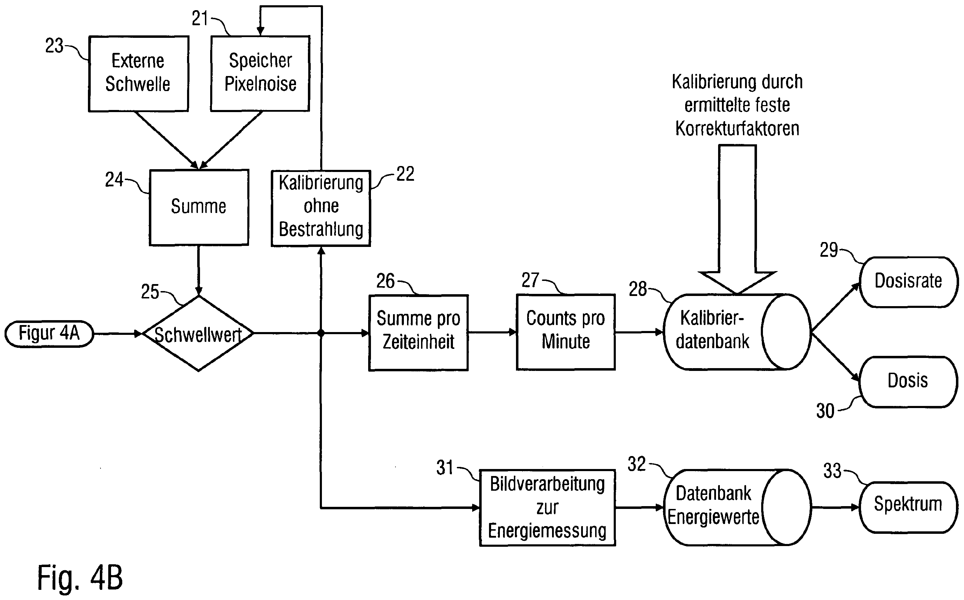

Die Figuren 4a und 4b zeigen das erfindungsgemäße Betriebsverfahren für die Mobiltelefone in Form eines Flussdiagramms, wobei nur die Verfahrensschritte dargestellt und beschrieben sind, mit denen die Auswertungseinheit 7 in Verbindung mit der Statistikeinheit 6 den Strahlungswert $D_1$ aus den Pixelwerten des Bildsensors 4 ermittelt.

Zunächst zeigen die Zeichnungen einen Bildsensor 15 mit zahlreichen matrixförmig angeordneten Bildelementen zur Strahlungsmessung. Bei dem Bildsensor 15 kann es sich beispielsweise um einen CCD-Sensor oder um einen CMOS-Sensor handeln.

In einem Schritt 16 erfolgt eine Werteerfassung der von dem Bildsensor 15 gemessenen Bilder mit einer Frame-Rate von 40-60 fps (frames per second). Alternativ ist beispielsweise auch eine Frame-Rate von 15-24 fps möglich. Optional sind auch Einzelbilder möglich, die dann ggf. mit Shutter-Zeiten, die Teilbilderaufnahmen entsprechen oder umgekehrt Langzeitbelichtungen mit ganz großen Shutter-Zeiten.

Die gemessenen Bilder werden dann in einem Schritt 17 in einem Bildspeicher gespeichert.

Anschließend erfolgt in einem Schritt 18 eine Differenzbildung zwischen dem in dem Schritt 17 gespeicherten aktuellen Bild und einem in einem Schritt 19 gespeicherten Referenzbild, wobei ein Referenzspeicher eine Durchschnittshelligkeit pro Bildelement (Pixel) von den vorherigen Bildaufnahmen enthält. Die somit erreichte Mittelung kann in Abhängigkeit von der aktuellen Differenz erfolgen, beispielsweise nach folgender Formel:

$$\mathtt{Ref\ =\ Ref\ \cdot\ n\ +\ neues\ Pixel\ \cdot\ m/(n+m)}$$

mit

| | |
|---|---|
| Ref: | Helligkeit des Referenzbilds |
| n: | Gewichtungsfaktor für die Berücksichtigung des Referenzbildes mit n+m=1 |
| m: | Gewichtungsfaktor für die Berücksichtigung des neuen Bildes mit n+m=1 |
| neues Pixel: | Helligkeit des neuen Bildes |

Die so ermittelte Differenz wird dann in einem Schritt 20 mit einem oberen Grenzwert und einem unteren Grenzwert verglichen, wobei ein Zählereignis ausgelöst wird, wenn der gemessene Differenzwert zwischen dem oberen Grenzwert und dem unteren Grenzwert liegt.

Optional besteht die in Figur 4b dargestellte Möglichkeit eines Speichers 21 für Pixelrauschen, der bei einem Kalibriervorgang 22 mit den Rauschwerten pro Pixel gefüllt wird. Dazu werden mehrere Messungen bei Dunkelheit und ohne zusätzliche Bestrahlung durchgeführt. Die einzelnen Differenzen zwischen aktuellem Bild und letztem Bild werden mit einer Matrix aufsummiert (Rauschwerte pro Pixel) und dann z.B. maximale Werte bzw. nach statistischer Auswertung die ermittelten Werte gespeichert (Gauß-Verteilung unter Berücksichtigung von einfallender Background-Strahlung). Darüber hinaus kann eine externe Schwelle 23 hinzugefügt werden, die auf die Pixelschwelle aus dem Speicher 21 in einem Schritt 24 aufaddiert werden kann, was für stabilere Ergebnisse sorgt.

Ein Schwellenwertvergleich 25 liefert dann ein analoges oder digitales Signal, wenn Schwellenwerte überschritten bzw. - bei negativem Vorzeichen - unterschritten werden. In einem Schritt 26 werden die Zählereignisse dann über eine bestimmte Zeiteinheit aufsummiert.

Daraufhin wird in einem Schritt 27 die Anzahl der Zählereignisse (Counts) pro Minute berechnet.

Über eine Kalibriertabelle 28 wird dann die Zuordnung zu einer Dosisleistung (z.B. aus Counts pro Minute) bzw. Dosis (aus Gesamtzahl der Counts) erstellt. Die Kalibrierungstabelle kann für eine Gruppe von Sensoren oder individuell erstellt werden durch einen Messvorgang mit kalibrierter Strahlungsquelle. Optional kann ein Korrekturfaktor zur vereinfachten Kalibrierung mit ein oder zwei Punkten vorgesehen sein.

Im Ergebnis wird dann in einem Schritt 29 eine Dosisrate und in einem Schritt 30 eine Dosis ausgegeben.

Darüber hinaus besteht auch die Möglichkeit für eine Bildverarbeitung 31 zur Ermittlung der Energiewerte der einfallenden Photonen. So lösen niedrigenergetische Photonen in der Regel nur ein Zählereignis in einem einzigen Bildelement des Bildsensors 4 aus. Hochenergetische Photonen führen dagegen zu einem Übersprechen zwischen benachbarten Bildelementen des Bildsensors 4, so dass eine Gruppe (Cluster) von mehreren benachbarten Bildelementen des Bildsensors 4 ein Zählereignis auslöst. Durch die Bildverarbeitung 31 können dann derartige Gruppen von aktivierten Bildelementen ermittelt werden, wodurch sich näherungsweise eine Spektralverteilung berechnen lässt. Die so gewonnenen Werte werden mit einer Datenbank 32 der Energiewerte verglichen, woraufhin dann in einem Schritt 33 ein Spektrum der einfallenden Strahlung ausgegeben wird.

Bezugszeichenliste:

| | | | | |
|---|---|---|---|---|
| 1 | Mobiltelefon | 21 | Speicher für Pixelrauschen |
| 2 | LCD-Display | 22 | Kalibriervorgang |
| 3 | Lautsprecher | 23 | Externe Schwelle |
| 4 | Bildsensor | 24 | Schritt "Summenbildung" |
| 5 | Strahlungssensor | 25 | Schwellenwertvergleich |
| 6 | Statistikeinheit | 26 | Schritt "Aufsummierung pro Zeiteinheit" |
| 7 | Recheneinheit | 27 | Schritt "Counts pro Minute" |
| 8 | Telefonmodul | 28 | Kalibriertabelle |
| 9 | Antenne | 29 | Ausgabe Dosisrate |
| 10 | GPS-Modul | 30 | Ausgabe Dosis |
| 11 | Temperatursensor | 31 | Bildverarbeitung |
| 12 | Stellglied | 32 | Datenbank der Energiewerte |
| 13 | Kühlelement | 33 | Ausgabe Spektrum |
| 14 | Abschwächer | $T_{CCD}$ | Temperaturwert des Bild-sensors |
| 15 | Bildsensor | $D_1$ | Strahlungswert |
| 16 | Schritt "Werteerfassung" | $D_2$ | Strahlungswert |
| 17 | Schritt "Speichern" | D | Strahlungswert |
| 18 | Schritt "Differenzbildung" | | |
| 19 | Schritt "Referenzbild" | | |
| 20 | Schritt "Schwellenwertprüfung" | | |

## Patentansprüche

1. Elektronisches Gerät (1), insbesondere Mobiltelefon (1), mit

   a) einem Bildsensor (4) mit mehreren Bildelementen zur Aufnahme eines Bildes, wobei der Bildsensor (4) auch für ionisierende Strahlung empfindlich ist, und
   b) einem zusätzlichen Strahlungssensor (5) zur Messung der ionisierenden Strahlung,

   **dadurch gekennzeichnet,**

   c) dass der Bildsensor (4) auch zur Messung der ionisierenden Strahlung dient, so dass das elektronische Gerät dazu eingerichtet ist, die ionisierende Strahlung mit zwei verschiedenen Sensortypen zu messen, und
   d) dass der Bildsensor (4) und der Strahlungssensor (5) unterschiedliche Messverfahren anwenden, um durch die Kombination des Bildsensors (4) mit dem Strahlungssensor (5) bei der Messung der ionisierenden Strahlung Redundanz zu schaffen.

2. Elektronisches Gerät (1) gemäß Anspruch 1,
   **dadurch gekennzeichnet,**

   a) **dass** das Gerät (1) eine Auswertungseinheit (6, 7) aufweist, die eingangsseitig mit dem Bildsensor (4) und mit dem Strahlungssensor (5) verbunden ist und dazu eingerichtet ist, aus den Ausgangssignalen des Bildsensors (4) und des Strahlungssensors (5) einen Strahlungswert zu berechnen, der die ionisierende Strahlung wiedergibt, insbesondere einen Dosiswert oder einen Dosisleistungswert, und/oder
   b) **dass** die Auswertungseinheit (6, 7) dazu eingerichtet ist, die Ausgangssignale der Bildelemente des Bildsensors (4) statistisch auszuwerten, und/oder
   c) **dass** die Auswertungseinheit (6, 7) dazu eingerichtet ist, das Ausgangssignal des Bildsensors (4) mit dem Ausgangssignal des Strahlungssensors (5) abzugleichen.

3. Elektronisches Gerät (1) nach einem der vorhergehenden Ansprüche, **dadurch gekennzeichnet,**

   a) **dass** der Bildsensor (4) ein CCD-Sensor oder ein CMOS-Sensor ist, und

b) **dass** der Strahlungssensor (5) ein Geiger-Müller-Zählrohr oder eine Photodiode, insbesondere ein PIN-Photodiode, ist.

4. Elektronisches Gerät (1) nach einem der vorhergehenden Ansprüche, **dadurch gekennzeichnet, dass** der Bildsensor (4) und der Strahlungssensor (5) unterschiedliche Leistungsmessbereiche aufweisen.

5. Elektronisches Gerät (1) nach einem der vorhergehenden Ansprüche, **dadurch gekennzeichnet,**

a) **dass** die Bildelemente des Bildsensors (4) und/oder der Strahlungssensor mindestens teilweise mit einem Abschwächer (14) bedeckt sind, wobei der Abschwächer (14) die einfallende ionisierende Strahlung abschwächt, und/oder
b) **dass** der Abschwächer (14) die einfallende Strahlung unterschiedlich stark abschwächt, und/oder
c) **dass** der Abschwächer (14) eine Dicke aufweist, die sich von einer Seite des Bildsensors (4) bzw. des Strahlungssensors zu der gegenüber liegenden Seite des Bildsensor (4) bzw. des Strahlungssensors keilförmig erweitert.

6. Elektronisches Gerät (1) nach Anspruch 5, **dadurch gekennzeichnet, dass** die Abschwächer (14) aus mindestens einem der folgenden Materialien bestehen:

a) Kupfer,
b) Aluminium,
c) Blei,
d) Polymethylmethacrylat.

7. Elektronisches Gerät (1) nach Anspruch 5 der 6,
**dadurch gekennzeichnet,**

a) **dass** die Abschwächer (14) der einzelne Bildelemente des Bildsensors (4) unterschiedliche spektrale Abschwächungscharakteristiken aufweisen,
b) **dass** die Auswertungseinheit (6, 7) dazu eingerichtet ist, aus den Ausgangssignalen der einzelnen Bildelemente des Bildsensor (4) eine spektrale Energieverteilung der einfallenden ionisierenden Strahlung zu berechnen.

8. Elektronisches Gerät (1) nach einem der vorhergehenden Ansprüche, **dadurch gekennzeichnet, dass** im Strahlengang des Strahlungssensors (5) ein Strahlungsfilter angeordnet ist.

9. Elektronisches Gerät (1) nach einem der Ansprüche 2 bis 8, **dadurch gekennzeichnet,**

a) **dass** das Gerät (1) einen Temperatursensor (11) aufweist zur Messung der Temperatur ($T_{CCD}$) des Strahlungssensor (5) und/oder des Bildsensors (4),
b) **dass** die Auswertungseinheit (6, 7) eingangsseitig mit dem Temperatursensor (11) verbunden ist und dazu eingerichtet ist, bei der Berechnung des Strahlungswerts die gemessene Temperatur ($T_{CCD}$) zu berücksichtigen, um Temperaturschwankungen zu kompensieren.

10. Elektronisches Gerät (1) nach einem der vorhergehenden Ansprüche, **gekennzeichnet durch** ein aktives Kühlelement (13), insbesondere ein Peltier-Element, zum aktiven Kühlen des Bildsensors (4), um die Messempfindlichkeit des Bildsensors (4) zu erhöhen.

11. Elektronisches Gerät (1) nach einem der vorhergehenden Ansprüche, **dadurch gekennzeichnet, dass** im Strahlengang des Bildsensors (4) und/oder des Strahlungssensors (5) ein Konverter angeordnet ist, insbesondere ein Szintillator, der die einfallende Strahlung aus einem schlecht detektierbaren Wellenlängenbereich in einen besser detektierbaren Wellenlängenbereich konvertiert, um den Messbereich zu erweitern.

12. Elektronisches Gerät (1) nach einem der vorhergehenden Ansprüche, **dadurch gekennzeichnet,**

a) **dass** zur Vermeidung auslesebedingter Totzeiten eine Kombination mehrerer Bildsensoren vorgesehen ist, und/oder
b) **dass** der Bildsensor (4) zahlreiche Bildzeilen mit jeweils mehreren Bildelementen aufweist, wobei der Bildsensor (4) das Bild zeilenweise abtastet und speichert, so dass der Bildsensor (4) jeweils nur in einer einzigen Zeile insensitiv ist.

13. Elektronisches Gerät (1) nach einem der vorhergehenden Ansprüche, **dadurch gekennzeichnet, dass** mehrere Strahlungssensoren räumlich verteilt angeordnet und/oder in unterschiedliche Richtungen ausgerichtet sind.

14. Elektronisches Gerät (1) nach einem der vorhergehenden Ansprüche, **dadurch gekennzeichnet,**

    a) **dass** der Bildsensor (4) relativ zu dem Gerät (1) in verschiedene Richtungen ausgerichtet werden kann, und/oder
    b) **dass** zum motorischen Ausrichten des Bildsensors (4) ein Stellmotor vorgesehen ist.

15. Elektronisches Gerät (1) nach einem der vorhergehenden Ansprüche, **dadurch gekennzeichnet, dass** zusätzlich zu dem Bildsensor (4) mehrere verschiedene Strahlungssensoren vorgesehen sind, insbesondere ein Geiger-Müller-Zählrohr und eine Photodiode.

**Claims**

1. An electronic device (1), in particular a mobile phone (1), with

    a) an image sensor (4) with several image elements for capturing an image, wherein the image sensor (4) is also sensitive to ionizing radiation, and
    b) an additional radiation sensor (5) for measurement of the ionizing radiation,

    **characterized in that**

    c) the image sensor (4) also serves for the measurement of the ionizing radiation, so that the electronic device is adapted to measure the ionizing radiation by two different types of sensors, and
    d) the image sensor (4) and the radiation sensor (5) apply different measurement methods to create redundancy for the measurement of the ionizing radiation by the combination of the image sensor (4) and the radiation sensor (5).

2. The electronic device (1) according to claim 1, **characterized in that**

    a) the device (1) has an evaluation unit (6, 7), which is connected on the input side with the image sensor (4) and with the radiation sensor (5) and which is adapted to calculate a radiation value from the output signals of the image sensor (4) and of the radiation sensor (5), which value reflects the ionizing radiation, in particular a dosage value or a dose rate value, and/or
    b) the evaluation unit (6, 7) is adapted to statistically evaluate the output signals of the image elements of the image sensor (4), and/or
    c) the evaluation unit (6, 7) is adapted to compare the output signal of the image sensor (4) with the output signal of the radiation sensor (5).

3. The electronic device (1) according to any one of the preceding claims, **characterized in that**

    a) the image sensor (4) is a CCD sensor or a CMOS sensor, and
    b) the radiation sensor (5) is a Geiger-Muller counter tube or a photodiode, in particular a PIN photodiode.

4. The electronic device (1) according to any one of the preceding claims, **characterized in that** the image sensor (4) and the radiation sensor (5) have different power measurement ranges.

5. The electronic device (1) according to any one of the preceding claims, **characterized in that**

    a) the image elements of the image sensor (4) and/or of the radiation sensor are covered at least partially by an attenuator (14), wherein the attenuator (14) attenuates the incident ionizing radiation, and/or
    b) the attenuator (14) attenuates the incident radiation to a different degree, and/or
    c) the attenuator (14) has a thickness, which extends wedge-shaped from a side of the image sensor (4) resp.

of the radiation sensor to the opposite side of the image sensor (4) resp. of the radiation sensor.

6. The electronic device (1) according to claim 5, **characterized in that** the attenuators (14) consist of at least one of the following materials:

    a) copper,
    b) aluminium,
    c) lead,
    d) polymethyl methacrylate.

7. The electronic device (1) according to claim 5 or 6, **characterized in that**

    a) the attenuators (14) of the individual image elements of the image sensor (4) have different spectral attenuation characteristics,
    b) the evaluation unit (6, 7) is adapted to calculate from the output signals of the individual image elements of the image sensor (4) a spectral energy distribution of the incident ionizing radiation.

8. The electronic device (1) according to any one of the preceding claims, **characterized in that** a radiation filter is arranged in the radiation path of the radiation sensor (5).

9. The electronic device (1) according to any one of claims 2 to 8, **characterized in that**

    a) the device (1) has a temperature sensor (11) for measurement of the temperature ($T_{CCD}$) of the radiation sensor (5) and/or of the image sensor (4),
    b) the evaluation unit (6, 7) is connected on the input side with the temperature sensor (11) and is adapted to take the measured temperature ($T_{CCD}$) into account for the calculation of the radiation value in order to compensate for temperature fluctuations.

10. The electronic device (1) according to any one of the preceding claims, **characterized by** an active cooling element (13), in particular a Peltier element, for active cooling of the image sensor (4) in order to increase the measuring sensitivity of the image sensor (4).

11. The electronic device (1) according to any one of the preceding claims, **characterized in that** a converter, in particular a scintillator, is arranged in the radiation path of the image sensor (4) and/or of the radiation sensor (5), which converter converts the incident radiation from a badly detectable wavelength range into a better detectable wavelength range in order to extend the measurement range.

12. The electronic device (1) according to any one of the preceding claims, **characterized in that**

    a) a combination of several image sensors is provided for to avoid dead time due to reading-out, and/or
    b) the image sensor (4) has numerous image lines with each several image elements, wherein the image sensor (4) scans and saves the image line by line, so that the image sensor (4) is insensitive each time only in a single line.

13. The electronic device (1) according to any one of the preceding claims, **characterized in that** several radiation sensors are spatially arranged in a distributed manner and/or are oriented in different directions.

14. The electronic device (1) according to any one of the preceding claims, **characterized in that**

    a) the image sensor (4) can be aligned in different directions relative to the device (1), and/or
    b) a servomotor is provided for motorized alignment of the image sensor (4).

15. The electronic device (1) according to any one of the preceding claims, **characterized in that,** in addition to the image sensor (4), several different radiation sensors are provided for, in particular a Geiger-Muller counter tube and a photodiode.

**Revendications**

1.  Appareil (1) électronique, en particulier téléphone mobile (1), avec

    a) un capteur d'images (4) avec plusieurs éléments d'image servant à prendre une image, dans lequel le capteur d'images (4) est sensible également à un rayonnement ionisant, et
    b) un capteur de rayonnement (5) supplémentaire servant à mesurer le rayonnement ionisant,

    **caractérisé en ce**

    c) que le capteur d'images (4) sert également à mesurer le rayonnement ionisant de sorte que l'appareil électronique soit conçu pour mesurer le rayonnement ionisant avec deux types de capteurs différents, et
    d) que le capteur d'images (4) et le capteur de rayonnement (5) utilisent différents procédés de mesure pour créer une redondance du fait de la combinaison du capteur d'images (4) et du capteur de rayonnement (5) lors de la mesure du rayonnement ionisant.

2.  Appareil (1) électronique selon la revendication 1,
    **caractérisé en ce**

    a) **que** l'appareil (1) présente une unité d'évaluation (6, 7), qui est reliée côté entrée au capteur d'images (4) et au capteur de rayonnement (5) et est conçue pour calculer à partir des signaux de sortie du capteur d'images (4) et du capteur de rayonnement (5) une valeur de rayonnement, qui reproduit le rayonnement ionisant, en particulier une valeur de dose ou une valeur de puissance de dose, et/ou
    b) **que** l'unité d'évaluation (6, 7) est conçue pour évaluer statistiquement les signaux de sortie des éléments d'image du capteur d'images (4), et/ou
    c) **que** l'unité d'évaluation (6, 7) est conçue pour comparer le signal de sortie du capteur d'images (4) au signal de sortie du capteur de rayonnement (5).

3.  Appareil (1) électronique selon l'une quelconque des revendications précédentes, **caractérisé en ce**

    a) **que** le capteur d'images (4) est un capteur CCD ou un capteur CMOS, et
    b) **que** le capteur de rayonnement (5) est un tube de comptage Geiger-Müller ou une photodiode, en particulier une photodiode à PIN.

4.  Appareil (1) électronique selon l'une quelconque des revendications précédentes, **caractérisé en ce que** le capteur d'images (4) et le capteur de rayonnement (5) présentent différentes plages de puissance.

5.  Appareil (1) électronique selon l'une quelconque des revendications précédentes, **caractérisé en ce**

    a) **que** les éléments d'image du capteur d'images (4) et/ou du capteur de rayonnement sont couverts au moins en partie d'un atténuateur (14), dans lequel l'atténuateur (14) atténue le rayonnement ionisant incident, et/ou
    b) **que** l'atténuateur (14) atténue plus ou moins fortement le rayonnement incident, et/ou
    c) **que** l'atténuateur (14) présente une épaisseur, qui s'élargit en forme de coin depuis un côté du capteur d'images (4) ou du capteur de rayonnement vers le côté opposé du capteur d'images (4) ou du capteur de rayonnement.

6.  Appareil (1) électronique selon la revendication 5, **caractérisé en ce que** les atténuateurs (14) sont constitués d'au moins un des matériaux suivants :

    a) cuivre,
    b) aluminium,
    c) plomb,
    d) polyméthacrylate de méthyle.

7.  Appareil (1) électronique selon la revendication 5 ou 6,
    **caractérisé en ce**

    a) **que** les atténuateurs (14) des divers éléments d'images du capteur d'images (4) présentent des caractéristiques d'atténuation spectrales différentes,
b) **que** l'unité d'évaluation (6, 7) est conçue pour calculer à partir des signaux de sortie des divers éléments d'image du capteur d'images (4) une répartition d'énergie spectrale du rayonnement ionisant incident.

**8.** Appareil (1) électronique selon l'une quelconque des revendications précédentes, **caractérisé en ce qu'**un filtre de rayonnement est disposé sur le chemin optique du capteur de rayonnement (5).

**9.** Appareil (1) électronique selon l'une quelconque des revendications 2 à 8, **caractérisé en ce**

a) **que** l'appareil (1) présente un capteur de température (11) servant à mesurer la température ($T_{CCD}$) du capteur de rayonnement (5) et/ou du capteur d'images (4),
b) **que** l'unité d'évaluation (6, 7) est reliée côté entrée au capteur de température (11) et est conçue pour tenir compte de la température mesurée ($T_{CCD}$) lors du calcul de la valeur de rayonnement pour compenser des fluctuations de température.

**10.** Appareil (1) électronique selon l'une quelconque des revendications précédentes, **caractérisé par** un élément de refroidissement (13) actif, en particulier un élément de Peltier, servant à refroidir de manière active le capteur d'images (4) pour élever la sensibilité de mesure du capteur d'images (4).

**11.** Appareil (1) électronique selon l'une quelconque des revendications précédentes, **caractérisé en ce qu'**est disposé sur le chemin optique du capteur d'images (4) et/ou du capteur de rayonnement (5) un convertisseur, en particulier un scintillateur, qui convertit le rayonnement incident d'une plage de longueurs d'onde ne pouvant pas être détectée correctement en une plage de longueurs d'onde pouvant être mieux détectée pour étendre la plage de mesure.

**12.** Appareil (1) électronique selon l'une quelconque des revendications précédentes, **caractérisé en ce**

a) **qu'**une combinaison de plusieurs capteurs d'images est prévue pour éviter tous temps morts liés à la lecture, et/ou
b) **que** le capteur d'images (4) présente de nombreuses lignes d'image avec respectivement plusieurs éléments d'image, dans lequel le capteur d'images (4) balaye et mémorise l'image ligne par ligne de sorte que le capteur d'images (4) soit insensible respectivement seulement dans une seule ligne.

**13.** Appareil (1) électronique selon l'une quelconque des revendications précédentes, **caractérisé en ce que** plusieurs capteurs de rayonnement sont disposés de manière répartie spatialement et/ou sont orientés dans différentes directions.

**14.** Appareil (1) électronique selon l'une quelconque des revendications précédentes, **caractérisé en ce**

a) **que** le capteur d'images (4) peut être orienté par rapport à l'appareil (1) dans des directions différentes, et/ou
b) **que** pour orienter de manière motorisée le capteur d'images (4), un moteur de réglage est prévu.

**15.** Appareil (1) électronique selon l'une quelconque des revendications précédentes, **caractérisé en ce qu'**en plus du capteur d'images (4), plusieurs capteurs de rayonnement différents sont prévus, en particulier un tube de comptage Geiger-Müller et une photodiode.

Fig. 1

Fig. 3

Fig. 2

$T_{CCD}$

Stellglied 12

Temperatur-sensor 11

$T_{CCD}$

4

Kühlelement $P_{KÜHL}$ CCD-Sensor Pixel-werte

6

Statistik-einheit $D_1$

13

$T_{CCD}$

Rechen-einheit

9

D

Telefon-modul

8

5

PIN-Photodiode $D_2$

7

Position

GPS-Modul

10

EP 2 771 719 B1

EP 2 771 719 B1

Fig. 4A

Fig. 4B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009056055 A1
- US 2009012745 A1
- GB 968189 A
- US 2004149918 A1
- EP 2011005353 W

**In der Beschreibung aufgeführte Nicht-Patentliteratur**

- **SANJOY MUKHOPADHYAY.** Field-deployable gamma-radiation detectors for DHS use. *PROCEEDINGS OF SPIE,* 01. Januar 2007, vol. 6706, ISSN 0277-786X, 670612-670612, 8
- **A. BARZILOV et al.** titleNetwork of wireless gamma ray sensors for radiological detection and identification /title. *PROCEEDINGS OF SPIE,* 27. April 2007, vol. 6579, ISSN 0277-786X, 654012-654012, 8